(19) Europäisches Patentamt
European Patent Office
Office européen des brevets

(11) EP 2 850 726 B1

(12) **EUROPEAN PATENT SPECIFICATION**

(45) Date of publication and mention
of the grant of the patent:
**20.07.2016 Bulletin 2016/29**

(51) Int Cl.:
*H01P 1/18* (2006.01)          *H03F 3/19* (2006.01)
*H03F 3/21* (2006.01)          *H03F 3/24* (2006.01)
*H03K 5/06* (2006.01)          *H03F 1/02* (2006.01)
*H01P 9/00* (2006.01)          *H01P 5/18* (2006.01)

(21) Application number: **13730358.2**

(22) Date of filing: **14.05.2013**

(86) International application number:
**PCT/IB2013/053904**

(87) International publication number:
**WO 2013/171665 (21.11.2013 Gazette 2013/47)**

(54) **CIRCUIT AND METHOD FOR GENERATING A VARIABLE DELAY IN AN ELECTROMAGNETIC SIGNAL CROSSING SAID CIRCUIT, IN PARTICULAR FOR USE IN A DOHERTY- CONFIGURED AMPLIFIER**

SCHALTUNG UND VERFAHREN ZUM ERZEUGEN EINER VARIABLEN VERZÖGERUNG IN EINEM DIESE SCHALTUNG KREUZENDEN ELEKTROMAGNETISCHEN SIGNAL, INSBESONDERE ZUR VERWENDUNG IN EINEM DOHERTY-KONFIGURIERTEN VERSTÄRKER

CIRCUIT ET PROCÉDÉ DE GÉNÉRATION D'UN RETARD VARIABLE D'UN SIGNAL ÉLECTROMAGNÉTIQUE TRAVERSANT LEDIT CIRCUIT, NOTAMMENT DANS UN AMPLIFICATEUR DE TYPE DOHERTY

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.05.2012 IT TO20120434**

(43) Date of publication of application:
**25.03.2015 Bulletin 2015/13**

(73) Proprietor: **Onetastic S.r.L.**
**25125 Brescia (IT)**

(72) Inventor: **BOMBELLI, Carlo**
**I-25030 Roncadelle (BS) (IT)**

(74) Representative: **Camolese, Marco et al**
**Metroconsult S.r.l.**
**Via Sestriere 100**
**10060 None (TO) (IT)**

(56) References cited:
JP-A- 2006 261 843          JP-A- 2011 040 869
US-A- 5 066 930          US-A1- 2003 042 979
US-A1- 2005 030 076

• TAEIK KIM ET AL: "A tunable transmission line phase shifter (TTPS)", PROCEEDINGS / 2004 IEEE INTERNATIONAL SYMPOSIUM ON CIRCUITS AND SYSTEMS : MAY 23 - 26, 2004, SHERATON VANCOUVER WALL CENTRE HOTEL, VANCOUVER, BRITISH COLUMBIA, CANADA, IEEE OPERATIONS CENTER, PISCATAWAY, NJ, 23 May 2004 (2004-05-23), pages I-972, XP010719489, ISBN: 978-0-7803-8251-0

**Description**

The present invention relates to a circuit and a method for generating a variable delay in an electromagnetic signal that crosses said circuit, in particular for use in an amplifier in Doherty configuration.

Applications are known in the art which require the presence of a circuit element capable of introducing a variable delay along the path of a signal.

At present, this requirement is typically met in a few different ways.

The simplest way of introducing a delay along the path of a signal is to have said signal transit along a constant-impedance line having such a length that said signal, travelling at a speed equal to the typical speed of the physical medium, takes a time equal to the desired delay to cover the conductive element involved.

An alternative way is to have said signal transit along a constant-impedance line whose electric length is varied by changing the material, and hence the dielectric constant thereof, used for making the line itself, since the wave propagation speed is related to the dielectric constant of the material that the dielectric substance is made of. In order to avoid any signal alterations, the line must have a known constant impedance compatible with the surrounding circuit elements.

The delay is typically made variable in two ways:

  1) the physical length of the line is modified, thus also modifying the length of the conductive element because, all other conditions being equal, if the physical length of the conductive element is doubled, the delay being introduced will be doubled as well; or
  2) the electric length of the line itself is modified.

The electric length A of a circuit is the relationship existing between that circuit and the length of the electromagnetic wave that goes through it or is treated by it. Said wavelength $\lambda$ is bound to the wave frequency f and to the mechanical dimensions of the circuit or line by the following relation:

$$\Lambda = L\,/\,\lambda = f \cdot L\,/\,c$$

where L is the greatest dimension of the circuit taken into account, e.g. the longest track to be travelled by the electromagnetic waves involved.

One application that requires the possibility of changing the electric length introduced along the signal path is the utilization of a Doherty amplifier to create, for example, a television transmitter capable of operating over a wide frequency range while still ensuring a level of efficiency close to the ideal one.

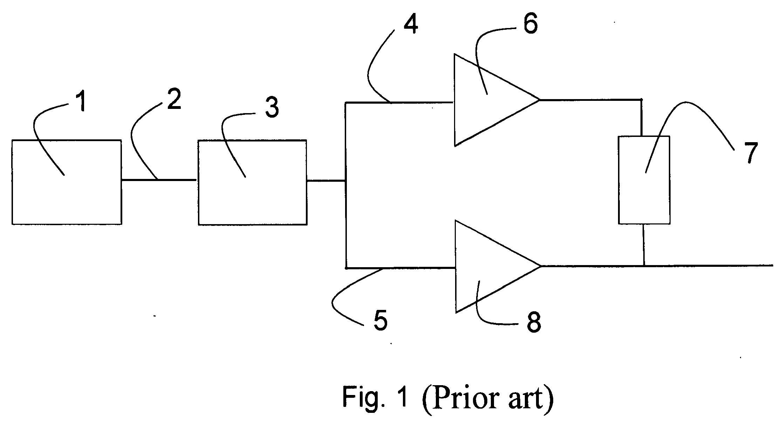

Figure 1 shows a block diagram of a Doherty amplifier. An input signal 2, generated by a signal source 1, is divided into two separate output signals 4,5 offset by 90° by means of a hybrid coupler 3 or a similar element.

The two output signals 4,5 are then applied to the input of two respective different amplifiers 6,8, which, being differently polarized (typically one as Class AB for the carrier and at least one as Class C for the peak), must then be recombined to recover the phase difference applied to the input.

To do so, an additional line 7 of electric length equal to 1/4 of the wave of the frequency of the input signal 2 is normally used, which, in addition to the correct phase, also ensures insulation between the two amplifiers 6,8 by acting as an impedance inverter.

It is the physical length of this line that represents the usable bandwidth limit of the Doherty amplifier, which is typically as low as 5-10% of the total band.

The Doherty scheme, therefore, while offering interesting advantages in terms of efficiency and power density, can only be used for relatively narrow-band applications.

Those prior-art devices wherein the physical length or the electric length of the line is modified are devices which are mechanically difficult to manufacture.

One example of a Doherty amplifier comprising a delay line is known from US patent application No. US 2011/0193624.

Said patent application proposes to vary the electric length of the line to an electric length equal to ¼ of the wave of the frequency of the input signal by mechanically lengthening or shortening it by means of sliding contacts, i.e. by sliding a pair of conductive contacts on a track that forms the transmission line. Depending on the point of contact, the physical length of the path will change. However, the mechanism described in said US patent application may lead to malfunctions over time, because problems may arise due to oxidation and false contacts.

Furthermore, in order to change the electric length it is necessary to remove the screws that secure the upper part of the circuit in a predetermined position; this typically also implies the necessity of dismounting the amplifier casing by removing the fastening screws thereof. As a consequence, the circuit of said US patent application cannot be servocontrolled.

Finally, the solution disclosed in said US patent application is complex from a practical viewpoint, because it requires the assembling of many components, such as rubber discs, adhesive, printed circuit, and the like. Other such art is known from US2005/030076, US 2003/042979, US5066930, JP2006-261843, and JP2011-040869.

It is therefore one object of the present invention to provide a circuit and a method for generating a variable delay in an electromagnetic signal that crosses said circuit, wherein no modifications are required to either the physical length or the electric length of the circuit.

It is another object of the present invention to provide a circuit and a method for generating a variable delay in an electromagnetic signal that crosses said circuit, wherein there are no sliding contacts or other moving mechanical parts subject to wear.

It is a further object of the present invention to provide a circuit and a method for generating a variable delay in an electromagnetic signal that crosses said circuit, wherein said circuit is easy and economical to manufacture.

It is a further object of the present invention to provide a circuit and a method for generating a variable delay in an electromagnetic signal that crosses said circuit, which can be easily implemented in any existing circuit.

These and other objects of the invention are achieved by a circuit and a method for generating a variable delay in an electromagnetic signal that crosses said circuit as claimed in the appended claims, which are intended to be an integral part of the present description.

In brief, the present invention allows to create a circuit based on coupled and interdependent lines, which circuit, via a remotely applied voltage variation, transfers a signal having a predictable phase delay within a frequency range as broad as one octave or more.

The circuit according to the invention has a wide variety of applications, since this type of control is required in many fields.

In addition, its simple construction makes it an ideal component for industrial production.

Further features of the invention are set out in the appended claims, which are intended to be an integral part of the present description.

The above objects will become more apparent from the following detailed description of a circuit and a method for generating a variable delay in an electromagnetic signal that crosses said circuit, with particular reference to the annexed drawings, wherein:

- Figure 1 is a diagram of a prior-art Doherty amplifier;
- Figure 2 illustrates an embodiment of a circuit according to the invention;
- Figure 3 shows a reference line that introduces a fixed delay on one of the two signal paths defined by the Doherty amplifier of Fig.1;
- Figures 4 and 5 show graphs that illustrate the trend of scattering parameters of a scattering matrix of the circuit of Figure 2;
- Figure 6 is a partial diagram of a Doherty amplifier comprising a circuit and a reference line according to Figures 2 and 3, respectively.

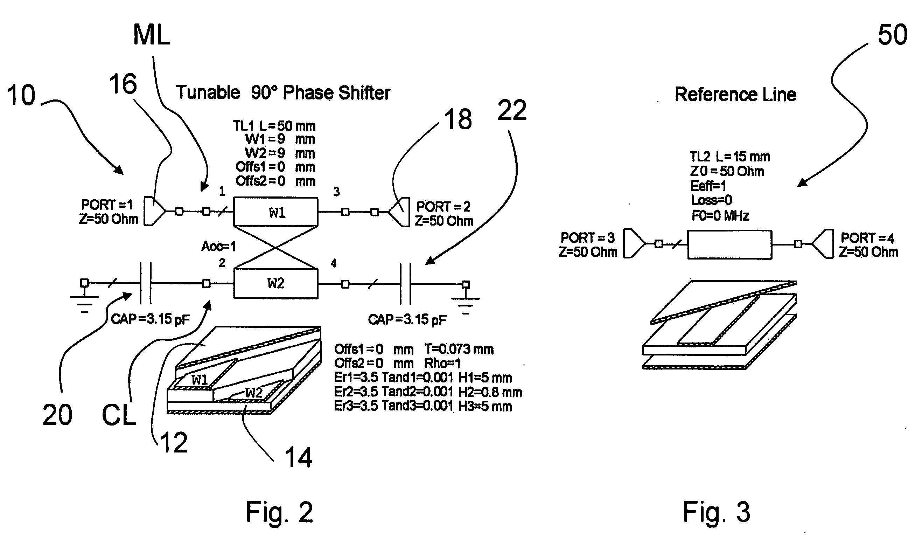

With reference to Figure 2, there is shown a circuit 10 comprising a main transmission line ML ("Main Line") and a secondary transmission line CL ("Coupled Line") that can be coupled to the main transmission line ML.

The main transmission line ML can be crossed by an electromagnetic signal for which a variable delay needs to be generated.

The main transmission line ML is, for example, a planar line comprised between a first ground plane 12 and a second ground plane 14. Its physical length is such that it constitutes, in the dielectric medium in which it is immersed, a length of $\lambda/4$ at a certain working frequency $F_0$, where $\lambda$ represents the wavelength of the electromagnetic signal going therethrough.

If the dielectric medium is a vacuum, then the propagation speed $V_p$ of the electromagnetic signal will be equal to the speed of light $c = 2.99 \cdot 10^8$ m/s.

To define the propagation speed of the electromagnetic signal, it is therefore necessary to know the dielectric medium employed for creating the main transmission line ML.

Electric permittivity, or dielectric constant, is a physical quantity that describes the manner in which an electric field affects, and is affected by, a dielectric medium; that is, it measures the attitude of a material towards transmitting the field. Said quantity is determined by the capability of a material to get polarized in the presence of the field, and hence to reduce the total electric field in the material.

Electric permittivity $\varepsilon$ is bound to relative dielectric permittivity $\varepsilon_r$, which is a dimensionless number always greater than 1, by the relation $\varepsilon = \varepsilon_0 \cdot \varepsilon_r$, where $\varepsilon_0$ is electric permittivity in a vacuum.

Relative permittivity $\varepsilon_r$ may, in particular conditions, be represented by means of a complex number, such as $R \pm j\Omega$, in accordance with first-order macroscopic polarization models, which describe the proportionality and offset between the polarization vector in the dielectric medium and the externally-applied field.

Its imaginary part, in particular, has a resonant trend: it is very small at low and high frequencies, but shows one or more peaks at fixed frequencies, due to the inertia of the atomic constituents of the material.

Let us now assume that the main transmission line ML is powered by a radio frequency source (not shown) operating at a normalized impedance 16, e.g. 50 $\Omega$, and that it is terminated at a user apparatus 18, or load, perfectly adapted thereto, in particular operating at 50 $\Omega$.

Of course, as the parameters of the main transmission line ML change, any other load and source impedance values may be taken into consideration.

Let us now assume that the secondary transmission line CL is coupled in a manner such that it is immersed in the same dielectric medium as the main transmission line ML (and therefore in the latter's electromagnetic field), and that it is tightly coupled to the main transmission line ML with a mutual coupling factor k approximately equal to 1 (substantially perfect coupling).

The secondary transmission line CL is terminated at a first end, corresponding to the radio-frequency source of the main transmission line ML, by a first variable-reactance element 20, and at a second end, corresponding to the load 18 of the main transmission line ML, by a second variable-reactance element 22.

The first and second variable-reactance elements 20, 22 are connected to means (not shown) adapted to simultaneously vary their reactance, so that the reactance values of the elements 20, 22 are substantially identical at both ends of the secondary transmission line CL.

The variable-reactance elements 20, 22 may consist of components or circuits of various kinds, provided that they are adapted to generate said simultaneous reactance variation. Said variation may also be generated by means of two mechanical elements, e.g. two variable capacitors controlled by a single command. Said means adapted to simultaneously vary the reactance of the elements 20,22 may advantageously be operated remotely.

The reactance variation may also be obtained indirectly through sub-circuits using electrically-controlled PIN diodes, such that their resistance variation is transformed into reactance variation. The same function can be obtained by controlling the Drain-Source resistance of a Jfet or a Mosfet, or other similar variable-resistance components.

The circuit 10 comprising the main transmission line ML and the secondary transmission line CL thus becomes a coupled resonant circuit 10 distributed over the entire main transmission line ML.

Said resonant circuit 10 behaves like a notch filter, that is, a band elimination filter, and it can be verified that, as the reactance value of the reactive elements 20,22 of the secondary transmission line CL changes, an absorption peak occurs in the main transmission line ML, corresponding to high load misadaptation at a certain frequency. Therefore, the main transmission line ML, initially created to be adapted to the load, is strongly perturbed from the electromagnetic viewpoint when it is coupled to the secondary transmission line CL (due to the ideally perfect coupling), so that it is possible to make the main transmission line ML in an arbitrary manner, with such physical width and length values that show no adaptation between the radio-frequency source and the load 18.

Such misadaptation also depends on the physical and electrical parameters of the main transmission line ML and of the secondary transmission line CL, on the coupling factor between the lines ML and CL, on the distance between the lines ML, CL and the ground planes 12,14, as well as on the reactance value of the reactive elements 20,22 that terminate the two ends of the secondary transmission line CL.

Also the input/output phase relations of the main transmission line ML must temporarily be considered as arbitrary.

It can now be observed that, as the reactance value of the reactive elements 20,22 of the secondary transmission line CL varies, another side effect occurs in addition to the above-mentioned notch filter, consisting of better adaptation between the radio-frequency source and the load 18 in the main transmission line ML, at a frequency lower than the absorption peak.

By appropriately varying the physical and electrical parameters of the lines ML and CL, i.e. length, width, distance of the ground planes, coupling factor, distance between the main transmission line ML and the secondary transmission line CL, this side effect can be beneficially increased and controlled.

By optimizing said physical and electrical parameters of the transmission lines ML and CL, it is possible to obtain a sharp adaptation peak, or matching, (return-loss), with values even greater than -30 dB (which is very good), at a different and lower frequency than that at which the absorption peak occurs.

This excellent adaptation peak value goes along with an excellent loss value ("insertion loss") of the order of a fraction of a decibel, e.g. less than 0.1 dB. It can therefore be stated that the main transmission line ML can be easily used as an efficient means for transmitting an electromagnetic signal at the frequency at which said side effect occurs.

It can also be demonstrated that, as the reactance values of the reactive elements 20,22 on the secondary transmission line CL are varied, a further side effect occurs, consisting of a regular and linear phase variation in the transmission of an electromagnetic signal on the main transmission line ML.

Finally, it can also be observed that the phase relationship (delay) introduced by the main transmission line ML stays at an adequately constant value as the adaptation peak frequency changes. For example, assuming that in a first value configuration the reactance values of the variable-reactance elements 20,22 of the secondary transmission line CL generate an absorption peak at the frequency of 980 MHz, due to the above observations there will be a corresponding adaptation peak at, for example, 620 MHz, and at this frequency a phase delay of, for example, 85 degrees will be measured between the input and the output of the main transmission line.

By changing the reactance values of the variable-reactance elements 20,22, the absorption peak will be shifted, for example, from 980 MHz to 800 MHz; at the same time, the adaptation peak will be shifted accordingly to, for example, 540 MHz. The phase relationship measured in this second value configuration will be very close to the 85 degrees measured in the first value configuration. Therefore, if an electromagnetic signal transmission frequency on the main transmission line ML is used which corresponds to the adaptation peak, approximately the same phase shift will always be obtained, for that adaptation peak, over a whole predetermined frequency range. As an alternative, it can be stated that, at any frequency of the predetermined frequency range, there will be a reactance value of the elements 20,22 which corresponds to a constant phase shift for a certain adaptation peak.

The aforementioned physical and electrical parameters of the main transmission line ML and of the secondary transmission line CL are thus optimized, with the help of a simulator, in a manner such that at least:

- the frequency at which the absorption peak occurs is always higher than the working frequency of the main transmission line ML, so that it will not disturb the transmission of the electromagnetic signal going therethrough;
- an adaptation peak is generated in the main transmission line ML at a frequency included among those for which the circuit is meant to be used;
- the adaptation peak is a function of the variation of the absorption peak, which depends on the reactance values of the reactive elements 20,22.

The physical and electrical parameters can be further optimized in a manner such that:

- the adaptation peak can be shifted within a very broad range, e.g. one octave or more;
- at the adaptation peak, the phase delay trend of the input signal varies in a controllable manner, such that it remains at a constant value, e.g. 90°;
- the bandwidth obtained at the adaptation peak, with a "constant" phase delay, is such as to allow it to be practically used for transmission of broadband channels, in particular greater than 20 MHz on a band centre of 500 MHz.

Still with reference to Figure 2, there are shown the physical and electric parameters of a circuit 10 for use on television broadcast channels (UHF band, 470 - 860 MHz).

In this example, the dielectric medium employed has, for example, a value $\varepsilon_r$ = 3.5, and the ground planes 12,14 are set at a distance of 5 mm from each other.

The main transmission line ML is in this case 50 mm long and 9 mm wide. The printed circuit board is 0.8 mm thick.

It can therefore be easily verified that any good electromagnetic simulation program can converge towards usable physical and electrical parameters of the transmission lines ML, CL when the targets are:

- high adaptation, in the main transmission line ML, to the frequency corresponding to the adaptation peak as the reactance value of the variable-reactance elements 20,22 changes;
- a constant associated phase delay, e.g. 90°;
- low loss on the transmission channel;
- simultaneous linear shifting of all said quantities, still with respect to the adaptation peak, as shown in the previous example.

With reference to Figure 3, there is shown an offset line 50 of a Doherty amplifier. The purpose of the reference line is to introduce a fixed delay, only linearly dependent on frequency, and hence adapted to improve, i.e. to make more constant, the delay difference between two different paths of a Doherty amplifier like the one shown in Figure 1.

The traditional solution is to insert an offset line in order to cause the two paths followed by the signal to give a desired delay to the two synchronous signals.

By selecting a suitable length of the offset line, which can be inserted between the main transmission line ML and the secondary transmission line CL, it is advantageously also possible to correct the phase/frequency error, with respect to a preset value, e.g. 90°, introduced by the circuit 10 according to the invention.

More in detail, due to the complexity of the reactive/resistive model, the circuit 10 generates an 80° phase delay at a frequency of, for example, 470 MHz, the 90° preset delay at a frequency of, for example, 650 MHz, and a 110° phase delay at a frequency of, for example, 860 MHz. Because this phase variation with respect to the preset 90° is linearly correlated to frequency, it can be eliminated by introducing an equal and opposite phase variation on the other path.

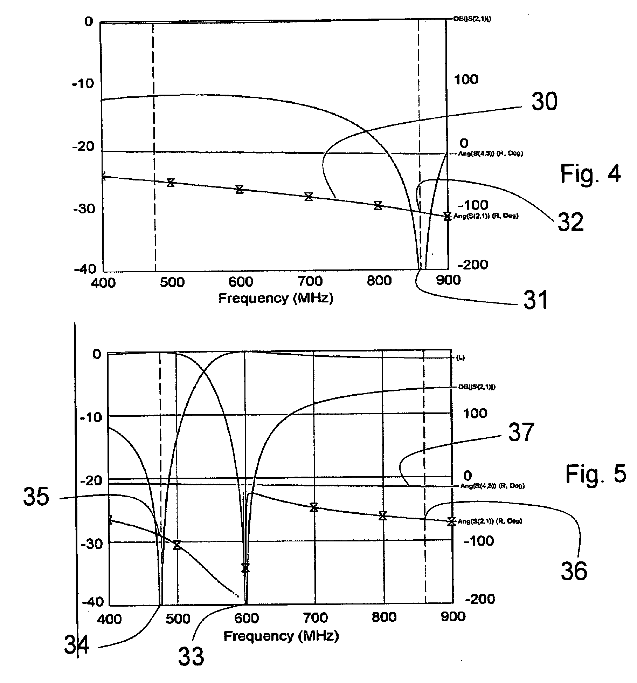

This artifice adds to Doherty amplifiers or other phase-dependent systems a further degree of freedom and allows to achieve more refined results. Let us consider, for example, the phasing of a complex system of antennae, or array, wherein a phase variation of a few degrees may cause the system itself to malfunction ("beam tilt"). Figures 4 and 5 show the trend of the scattering parameters of a scattering matrix relating to the circuit 10 of Figure 2.

With reference to Figure 4, the absorption peak generated by the variable-reactance elements 20,22 lies outside the graph area, e.g. it occurs at 1100 MHz, whereas the corresponding adaptation peak 31 occurs at 860 MHz (upper end of the UHF band).

A phase delay of approximately 110° is measured on a line 30 indicating the phase value 32.

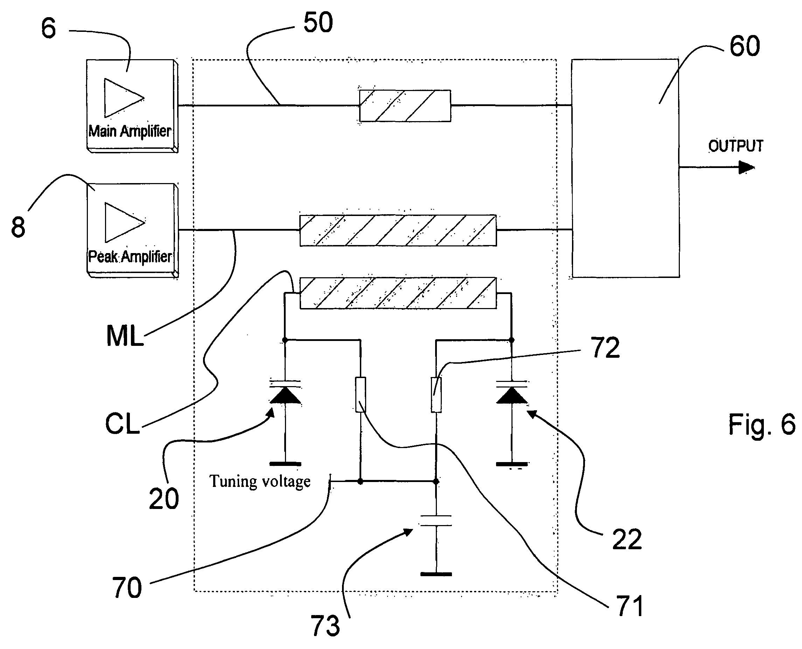

When the reactance of the reactive elements 20,22 is varied, Figure 5 shows the absorption peak 33 at 600 MHz, which is dependent on the value of the variable-reactance elements 20,22 on the secondary transmission line CL, and the adaptation peak 34 at 470 MHz (lower end of the UHF band). The phase value 35 corresponds to approximately 90°. Therefore, from one end to the other of the UHF band (470-860 MHz) there is an associated delay variation as small as 20° (+/- 10°). By inserting an adequately selected offset line 50, the phase trend of which is represented by line 32, on the other one of the two paths of the Doherty amplifier, such variation can be totally cancelled to obtain a constant delay throughout the UHF band. With reference to Figure 6, there is shown a partial diagram of a Doherty amplifier, wherein a first path, defined between a main amplifier 6 and a combiner 60, comprises an offset line 50, whereas a second path, defined between a peak amplifier 8 and the combiner 60, comprises the circuit 10 according to the invention, where one can discern the main transmission line ML, the secondary transmission line CL, and the reactive elements 20,22, in particular PIN diodes.

The polarization voltage of such PIN diodes can be varied by applying a tuning voltage to a node 70, which is then relayed to the cathode of the PIN diodes 20,22 through respective impedances 71,72 and a grounded coupling capacitor 73. The variation of the reactance of the reactive elements 20,22 is thus obtained indirectly through a variation of their resistive behaviour.

The features of the present invention, as well as the advantages thereof, are apparent from the above description.

A first advantage of the circuit according to the invention is that it does not require any modifications to the physical and electrical lengths of the circuit in order to be adapted to different frequency ranges.

A second advantage of the present invention is that the circuit according to the present invention has no moving mechanical parts.

A further advantage of the circuit according to the present invention is that it can be manufactured in a simple and economical manner.

Yet another advantage of the circuit and method according to the present invention is that they can both be easily implemented in a new circuit or an existing one.

The power circulating in the variable-reactance elements is very low, and depends on the factor of merit Q of the elements themselves and of the components in use. Through a careful selection of the active components, it is possible to treat high signal levels in the main transmission line ML.

A further advantage of the circuit and method according to the present invention is that the offset is directly introduced on the main transmission line, resulting in the advantage of galvanic insulation between the electromagnetic signal in transit on the main transmission line and the signal on the secondary transmission line.

In this way, the second transmission line can be subjected to direct or alternating voltages without any interference with the primary signal.

If varicap diodes are used as reactive elements, at high power levels they will have to be of a type for relatively high voltages, and will have to be selected to have as low a series resistance and as high an operating voltage as possible. For better results, it is appropriate to connect two or more varicap diodes in series or in series/parallel for each output, at the beginning and at the end of the secondary transmission line. Since this provides an anode-to-anode and cathode-to-cathode arrangement, the rectified AC voltage will be cancelled out.

The varicap diodes should preferably operate in that section of their variation curve C/V which corresponds to the lowest capacity values, because this function section is more linear and because this makes it possible to operate with high voltages and to handle higher power levels with less phase and amplitude distortion.

For higher power levels, one may use "gentle" PINs, with suitable phase shifters, to transform the resistive variation of the same PINs into a purely reactive variation.

The circuit and method for generating a variable delay in an electromagnetic signal that crosses said circuit described herein by way of example may be subject to many possible variations without departing from the novelty spirit of the inventive idea; it is also clear that in the practical implementation of the invention the illustrated details may have different shapes or be replaced with other technically equivalent elements. For example, the first and second transmission lines may be implemented by using various methods.

Among the various methods of implementation of the transmission lines, the most comfortable and easily reproducible one is the planar method based on striplines coupled through the dielectric layers of a support (PCB).

However, they may also be implemented by using coaxial concentric lines, or within containers adapted to create transmission lines by means of internal lines.

The choice regarding the method of implementation of the transmission lines merely depends on application-related considerations.

It can therefore be easily understood that the present invention is not limited to a circuit and a method for generating a variable delay in an electromagnetic signal that crosses said circuit, but may be subject to many modifications, improvements or replacements of equivalent parts and elements without departing from the inventive idea, as clearly specified in the following claims.

## Claims

1. A method for generating a variable delay in an electromagnetic signal that crosses a main transmission line (ML), **characterized by**:

   - coupling to said main transmission line (ML) a secondary transmission line (CL) terminated at both ends by respective variable-reactance circuit elements (20,22), wherein said main transmission line (ML) and said secondary transmission line (CL) are immersed in the same dielectric medium at a distance from each other;
   - simultaneously varying a reactance value of said variable-reactance circuit elements (20,22);
   - selecting said reactance value by varying physical and electrical parameters of said main transmission line (ML) and of said secondary transmission line (CL), so as to obtain, on said main transmission line (ML), an absorption peak at an absorption frequency higher than a predetermined working frequency of said main transmission line (ML), and an adaptation peak at a frequency lower than said absorption frequency, said adaptation peak corresponding to said predetermined working frequency.

**2.** A method according to claim 1, wherein said physical and electrical parameters comprise: length and width of said transmission lines (ML, CL), coupling factor (k) between said transmission lines (ML,CL), said distance, and the distance between said lines (ML,CL) and respective ground planes (12,14).

**3.** A method according to claim 1, wherein said reactance value can be modified remotely.

**4.** A method according to claim 1, wherein said reactance value is further selected in a manner such that:

- said adaptation peak can be shifted within a range, in particular one octave or more;
- at the adaptation peak, the phase delay trend of the input signal varies in a controllable manner such that it remains at a constant value;
- the bandwidth obtained at the adaptation peak is such as to allow it to be used for transmission of broadband channels, in particular greater than 20 MHz on a band centre of 500 MHz.

**5.** A method according to claim 1, further comprising the insertion of an offset line (50) between said main transmission line (ML) and said secondary transmission line (CL).

**6.** A circuit (10) adapted to generate a variable delay in an electromagnetic signal, comprising a main transmission line (ML) crossed by said electromagnetic signal, **characterized in that** it comprises:

- a secondary transmission line (CL), coupled to said main transmission line (ML) and terminated at both ends by respective variable-reactance circuit elements (20,22), wherein said main transmission line (ML) and said secondary transmission line (CL) are immersed in the same dielectric medium at a distance from each other;
- means for simultaneously varying a reactance value of said variable-reactance circuit elements (20,22), so that said reactance value generates, on said main transmission line (ML), an absorption peak at an absorption frequency greater than a predetermined working frequency of said main transmission line (ML), and an adaptation peak at a frequency lower than said absorption frequency, said adaptation peak corresponding to said predetermined working frequency.

**7.** A circuit according to claim 6, wherein said means for simultaneously varying a reactance value of said variable-reactance circuit elements (20,22) can be operated remotely.

**8.** A circuit according to claim 6, wherein said variable-reactance circuit elements (20,22) comprise one of the following circuit elements: variable capacitors; varicap diodes; PIN diodes; JFets; Mosfets; gentle PINs.

**9.** A circuit according to claim 8, wherein each one of said circuit elements (20,22) comprises two or more varicap diodes connected in series or in series-parallel.

**10.** A circuit according to claim 9, wherein said varicap diodes operate in that section of their variation curve CN which corresponds to the lowest capacity values.

**11.** A circuit according to one or more of claims 6 to 10, wherein said circuit further comprises an offset line (50) sized in a manner such that the phase delay introduced by said circuit is constant for at least one specific frequency range, in particular for the UHF band.

**12.** A circuit according to one or more of claims 6 to 11, wherein said main transmission line (ML) and said secondary transmission line (CL) are implemented in a planar manner based upon strip-lines coupled through the dielectric layers of a printed circuit board.

**13.** A circuit according to one or more of claims 6 to 11, wherein said main transmission line (ML) and said secondary transmission line (CL) are implemented as coaxial concentric lines.

**14.** A Doherty type amplifier comprising a delay line implemented by means of the circuit according to one or more of claims 6 to 13.

**Patentansprüche**

**1.** Verfahren zum Generieren einer variablen Verzögerung in einem elektromagentischen Signal das eine Hauptübertragungsleitung (ML) durchquert, **gekennzeichnet durch**:

- das Koppeln einer zweiten Übertragungsleitung (CL) mit der Hauptübertragungsleitung (ML), wobei die zweite Übertragungsleitung (CL) an beiden Enden jeweils mit einem variablen Reaktanzschaltungselement (20, 22) abgeschlossen ist, wobei die Hauptübertragungsleitung (ML) und die zweite Übertragungsleitung (CL) in das gleiche dielektrische Medium in einem Abstand voneinander eingelassen sind;
- gleichzeitiges Variieren eines Reaktanzwertes der variablen Reaktanzschaltungselemente (20, 22);
- Auswählen des Reaktanzwertes **durch** Variieren physikalischer und elektrischer Parameter der Hauptübertragungsleitung (ML) und der zweiten Übertragungsleitung (CL), um auf der Hauptübertragungsleitung (ML) einen Absorptionsspitzenwert bei einer Absorptionsfrequenz, die höher als eine vorbestimmte Arbeitsfrequenz der Hauptübertragungsleitung (ML) ist, und einen Adaptionsspitzenwert bei einer Frequenz, die niedriger als die Absorptionsfrequenz ist, zu erhalten, wobei der Adaptionsspitzenwert der vorbestimmten Arbeitsfrequenz entspricht.

2. Verfahren nach Anspruch 1, wobei die physikalischen und elektrischen Parameter umfassen:

Länge und Querschnitt der Übertragungsleitungen (ML, CL), Kopplungsfaktor (k) zwischen den Übertragungsleitungen (ML, CL), den genannten Abstand, und den jeweiligen Abstand zwischen den Leitungen (ML, CL) zu den entsprechenden Masseflächen (12, 14).

3. Verfahren nach Anspruch 1, wobei der Reaktanzwert aus der Ferne modifiziert werden kann.

4. Verfahren nach Anspruch 1, wobei der Reaktanzwert ferner in einer Weise ausgewählt wird, so dass:

- der Adaptionsspitzenwert innerhalb eines Bereichs, insbesondere einer Oktave oder mehr, verschoben werden kann;
- im Adaptionsspitzenwert die Phasenverzögerungstendenz des Eingangssignals in einer kontrollierbaren Weise variiert, so dass er auf einem konstanten Wert verbleibt;
- die Bandbreite, die beim Adaptionsspitzenwert erhalten wird so ist, um ihn zur Übertragung von Breitbandkanälen, insbesondere größer als 20 MHz mit einer Bandmittenfrequenz von 500 MHz, zu verwenden.

5. Verfahren nach Anspruch 1, ferner umfassend das Einfügen einer Offsetleitung (50) zwischen die Hauptübertragungsleitung (ML) und die zweite Übertragungsleitung (CL).

6. Schaltung (10), die eingerichtet ist, um eine variable Verzögerung in einem elektromagnetischen Signal zu erzeugen, umfassend eine Hauptübertragungsleitung (ML) die von dem elektromagentischen Signal durchquert wird, **dadurch gekennzeichnet, dass** sie umfasst:

- eine zweite Übertragungsleitung (CL), die mit der Hauptübertragungsleitung (ML) verbunden ist, und an beiden Enden jeweils mit einem variablen Reaktanzschaltungselement (20, 22) abgeschlossen ist, wobei die Hauptübertragungsleitung (ML) und die zweite Übertragungsleitung (CL) in das gleiche dielektrische Medium in einem Abstand voneinander eingelassen sind;
- Mittel zum gleichzeitigen Variieren eines Reaktanzwertes der variablen Reaktanzschaltungselemente (20, 22), so dass der Reaktanzwert auf der Hauptübertragungsleitung (ML) einen Absorptionsspitzenwert bei einer Absorptionsfrequenz, die größer als eine vorbestimmte Arbeitsfrequenz der Hauptübertragungsleitung (ML) ist, und einen Adaptionsspitzenwert bei einer Frequenz, die niedriger als die Absorptionsfrequenz ist, generiert, wobei der Adaptionsspitzenwert der vorbestimmten Arbeitsfrequenz entspricht.

7. Schaltung nach Anspruch 6, wobei die Mittel zum gleichzeitigen Variieren des Reaktanzwerts der variablen Reaktanzschaltungselemente (20, 22) aus der Ferne bedient werden können.

8. Schaltung nach Anspruch 6, wobei die variablen Reaktanzschaltungselemente (20, 22) eines der folgenden Schaltungselemente umfassen:

variable Kondensatoren; Abstimmdioden; PIN Dioden; JFets; Mosfets; flache PINs.

9. Schaltung nach Anspruch 8, wobei jedes der Schaltungselemente (20, 22) jeweils zwei oder mehr Abstimmdioden, die in Serienschaltung oder in Serien-Parallelschaltung verbunden sind, umfasst.

10. Schaltung nach Anspruch 9, wobei die Abstimmdioden in dem Bereich ihrer Variationskurve C/V, die den geringsten Kapazitätswerten entspricht, arbeiten.

11. Schaltung nach einem oder mehreren der Ansprüche 6 bis 10, wobei die Schaltung ferner eine Offsetleitung (50) umfasst, die in einer Weise dimensioniert ist, so dass die Phasenverzögerung, die durch die Schaltung eingebracht wird, für zumindest einen spezifischen Frequenzbereich, insbesondere für das UHF Band, konstant ist.

12. Schaltung nach einem oder mehreren der Ansprüche 6 bis 11, wobei die Hauptübertragungsleitung (ML) und die zweite Übertragungsleitung (CL) in einer planaren Weise basierend auf Streifenleitungen, die durch die dielektrischen Lagen einer gedruckten Schaltung verbunden sind, implementiert sind.

13. Schaltung nach einem oder mehreren der Ansprüche 6 bis 11, wobei die Hauptübertragungsleitung (ML) und die zweite Übertragungsleitung (CL) als coaxiale konzentrische Leitungen implementiert sind.

**14.** Doherty-Verstärker umfassend eine Verzögerungsleitung, die durch Mittel einer Schaltung nach einem oder mehreren der Ansprüche 6 bis 13 implementiert ist.

**Revendications**

**1.** Procédé de génération d'un retard variable dans un signal électromagnétique traversant une ligne de transmission principale (ML), **caractérisé en ce qu'**il comprend :

- un couplage à ladite ligne de transmission principale (ML) d'une ligne de transmission secondaire (CL) terminée aux deux extrémités par des éléments de circuit à réactance variable (20, 22) respectifs, ladite ligne de transmission principale (ML) et ladite ligne de transmission secondaire (CL) étant immergées dans le même milieu diélectrique à une distance l'une de l'autre ;
- une variation simultanée d'une valeur de réactance desdits éléments de circuit à réactance variable (20, 22) ;
- une détermination de ladite valeur de réactance en faisant varier des paramètres physiques et électriques de ladite ligne de transmission principale (ML) et de ladite ligne de transmission secondaire (CL), de façon à obtenir, sur ladite ligne de transmission principale (ML), un pic d'absorption à une fréquence d'absorption supérieure à une fréquence de fonctionnement prédéterminée de ladite ligne de transmission principale (ML), et un pic d'adaptation à une fréquence inférieure à ladite fréquence d'absorption, ledit pic d'adaptation correspondant à ladite fréquence de fonctionnement prédéterminée.

**2.** Procédé selon la revendication 1, dans lequel lesdits paramètres physiques et électriques comprennent : une longueur et une largeur desdites lignes de transmission (ML, CL), un facteur de couplage (k) entre lesdites lignes de transmission (ML, CL), ladite distance, et la distance entre lesdites lignes (ML, CL) et les plans de masse (12, 14) respectifs.

**3.** Procédé selon la revendication 1, dans lequel ladite valeur de réactance peut être modifiée à distance.

**4.** Procédé selon la revendication 1, dans lequel ladite valeur de réactance est en outre déterminée de manière à ce que :

- ledit pic d'adaptation puisse être déplacé dans une plage, en particulier d'une octave ou plus ;
- au pic d'adaptation, la tendance de retard de phase du signal d'entrée varie de manière maîtrisable de sorte qu'elle reste à une valeur constante ;
- la largeur de bande obtenue au pic d'adaptation soit de nature à permettre son utilisation pour une transmission de canaux à large bande, en particulier supérieure à 20 MHz à une fréquence médiane de 500 MHz.

**5.** Procédé selon la revendication 1, comprenant en outre l'insertion d'une ligne de décalage (50) entre ladite ligne de transmission principale (ML) et ladite ligne de transmission secondaire (CL).

**6.** Circuit (10) agencé pour générer un retard variable dans un signal électromagnétique, comprenant une ligne de transmission principale (ML) traversée par ledit signal électromagnétique, **caractérisé en ce qu'**il comprend :

- une ligne de transmission secondaire (CL), couplée à ladite ligne de transmission principale (ML) et terminée aux deux extrémités par des éléments de circuit à réactance variable (20, 22) respectifs, ladite ligne de transmission principale (ML) et ladite ligne de transmission secondaire (CL) étant immergées dans le même milieu diélectrique à une distance l'une de l'autre ;
- des moyens pour faire varier simultanément une valeur de réactance desdits éléments de circuit à réactance variable (20, 22), de sorte que ladite valeur de réactance génère, sur ladite ligne de transmission principale (ML), un pic d'absorption à une fréquence d'absorption supérieure à une fréquence de fonctionnement prédéterminée de ladite ligne de transmission principale (ML), et un pic d'adaptation à une fréquence inférieure à ladite fréquence d'absorption, ledit pic d'adaptation correspondant à ladite fréquence de fonctionnement prédéterminée.

**7.** Circuit selon la revendication 6, dans lequel lesdits moyens pour faire varier simultanément une valeur de réactance desdits éléments de circuit à réactance variable (20, 22) peuvent être commandés à distance.

**8.** Circuit selon la revendication 6, dans lequel lesdits éléments de circuit à réactance variable (20, 22) comprennent un des éléments de circuit suivants : des condensateurs variables ; des diodes varactors, des diodes PIN ; des JFet ; des Mosfet ; des PIN doux.

**9.** Circuit selon la revendication 8, dans lequel chacun desdits éléments de circuit à réactance variable (20, 22) comprend deux diodes varactors ou plus connectées en série ou en série-parallèle.

**10.** Circuit selon la revendication 9, dans lequel lesdites diodes varactors fonctionnent dans la section de leur courbe de variation C/V qui correspond aux valeurs de capacité les plus faibles.

11. Circuit selon une ou plusieurs des revendications 6 à 10, dans lequel ledit circuit comprend en outre une ligne de décalage (50) dimensionnée de manière à ce que le retard de phase introduit par ledit circuit soit constant pour au moins une plage de fréquences spécifique, en particulier pour la bande UHF.

12. Circuit selon une ou plusieurs des revendications 6 à 11, dans lequel ladite ligne de transmission principale (ML) et ladite ligne de transmission secondaire (CL) sont implémentées dans une disposition plane à partir de lignes à rubans couplées à travers les couches diélectriques d'une carte de circuit imprimé.

13. Circuit selon une ou plusieurs des revendications 6 à 11, dans lequel ladite ligne de transmission principale (ML) et ladite ligne de transmission secondaire (CL) sont implémentées sous forme de lignes concentriques coaxiales.

14. Amplificateur de type Doherty comprenant une ligne à retard implémentée au moyen du circuit selon une ou plusieurs des revendications 6 à 13.

Fig. 1 (Prior art)

Reference Line

TL2 L=15 mm
Z0 = 50 Ohm
Eeff=1
Loss=0
F0=0 MHz

PORT=3
Z=50 Ohm

PORT=4
Z=50 Ohm

Fig. 3

50

Tunable 90° Phase Shifter

ML

16

10

PORT=1
Z=50 Ohm

TL1 L=50 mm
W1=9  mm
W2=9  mm
Offs1=0  mm
Offs2=0  mm

Acc=1

W1

W2

1

2

3

4

PORT=2
Z=50 Ohm

18

22

CAP=3.15 pF

CAP=3.15 pF

CL

20

12

14

Offs1=0  mm   T=0.073 mm
Offs2=0  mm   Rho=1
Er1=3.5 Tand1=0.001 H1=5 mm
Er2=3.5 Tand2=0.001 H2=0.8 mm
Er3=3.5 Tand3=0.001 H3=5 mm

Fig. 2

**Fig. 4**

**Fig. 5**

Fig. 6

EP 2 850 726 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110193624 A
- US 2005030076 A
- US 2003042979 A
- US 5066930 A
- JP 2006261843 A
- JP 2011040869 A